# EUROPEAN PATENT APPLICATION

(11) **EP 4 597 556 A1**
(43) Date of publication of application: **06.08.2025**
(21) Application number: 25153460.8
(22) Date of filing: 23.01.2025
(51) Int. Cl.: H01L 21/67

(54) **HIGH PRESSURE SUBSTRATE PROCESSING APPARATUS AND COLD TRAP USED THEREFOR**

(30) Priority: 24.01.2024 KR 20240010721
(71) Applicant: HPSP Co., Ltd., Hwaseong-si, Gyeonggi-do 18449 (KR)
(72) Inventor: YOON, HYE SEONG, 18449 Gyeonggi-do (KR); AHN, Jae Beom, 18449 Gyeonggi-do (KR)
(74) Representative: von Bülow & Tamada

(57) **Abstract**

Disclosed are a high pressure substrate processing apparatus and a cold trap used therefor. The cold trap may include a casing, a cooling plate, and a cooling medium line. The casing may have an internal space communicating with an inlet and an outlet. The cooling plate may be disposed in the internal space and cool and primarily capture byproducts included in mixed gas flowing into the internal space from a substrate processing area through the inlet. The cooling medium line may accommodate a cooling medium while being disposed behind the cooling plate along a flow direction of the mixed gas from the inlet toward the outlet in the internal space and connected to the cooling plate and may be configured to discharge heat from the mixed gas to the cooling medium. The cooling medium line may define a well space configured to cool and secondarily capture the byproducts.

## Description

### BACKGROUND

### Field

The present disclosure relates to a cold trap and a high pressure substrate processing apparatus including the same.

### Description of the Related Art

In general, various processing may be performed on a semiconductor wafer during a manufacturing process of a semiconductor device. An example of the processing may include oxidation, nitriding, deposition, ion implantation, or the like. The example may also include a hydrogen or deuterium heat treatment process to improve interface properties of the semiconductor device.

A process gas may be supplied to a chamber, and the process gas may act on the semiconductor wafer for the processing. During the action of the process gas, byproducts such as particles may sometimes be emitted from the semiconductor wafer.

In an exhaust stage after the processing, the byproducts may be discharged by being mixed with the process gas. The byproducts may be gaseous in a high-temperature environment, and solidified either during a process of leaving the chamber or after leaving the chamber.

The solidified byproducts may stick to an inner wall of a gas exhaust line, a gas discharge valve, or other equipment such as a scrubber or a vacuum pump. Accordingly, a flow path of the line or the valve may be blocked. A section where this problem occurs may be quite long along a flow path of the byproducts. In response to the problem, a device has been used to capture the byproducts.

### SUMMARY

According to the inventor's understanding, a byproduct capture device may capture byproducts by cooling a discharged gas, and its cooling performance may determine byproduct capture efficiency. The byproduct capture device may be traditionally installed directly in front of a scrubber, thus addressing a problem of clogging in a flow path between the scrubber and a vacuum pump.

An object of the present disclosure is to provide a high pressure substrate processing apparatus capable of preventing byproducts from adversely affecting a gas discharge device used for adjusting a gas discharge amount of a chamber and its following parts, and a cold trap used therefor.

Another object of the present disclosure is to provide a high pressure substrate processing apparatus capable of minimizing a burden of high pressure design on a cold trap even when the cold trap is used in a high pressure processing apparatus, and a cold trap used therefor.

The technical problems to be solved by the present disclosure are not limited to the aforementioned problems, and any other technical problems not mentioned herein will be clearly understood from the following description by those skilled in the art to which the present disclosure pertains.

According to an embodiment of the present disclosure, provided is a high pressure substrate processing apparatus including: an internal chamber accommodating a substrate to be processed; an external chamber including a housing having a protecting area and a partition plate partitioning the protecting area into a high-temperature region accommodating the internal chamber and a low-temperature region having a temperature lower than that in the high-temperature region; a gas supply module configured to supply a reaction gas for processing the substrate to the internal chamber to reach a first pressure higher than atmospheric pressure, and to supply a protective gas to a space between the external chamber and the internal chamber to reach a second pressure set in relation to the first pressure; a gas exhaust module including a gas exhaust line communicating with the internal chamber and passing through the low-temperature region and configured to exhaust mixed gas including the reaction gas and byproducts resulting from the processing; and a cold trap including a cooling plate for cooling and capturing the byproducts in the mixed gas, and disposed in the low-temperature region while communicating with the gas exhaust line.

The cold trap may further include a cooling medium line through which a cooling medium flows internally, and the cooling plate may be connected to the cooling medium line and discharge heat from the mixed gas to the cooling medium.

The cooling medium line may include a cooling coil wound into a coil shape, and the cooling plate may be coupled to the cooling coil.

The cooling plate may include a hollow part communicating with the cooling medium line and receiving the cooling medium.

The cold trap may further include a casing accommodating the cooling plate, and an entire section of the cooling plate along an outer peripheral direction may allow the mixed gas to flow through by being spaced apart from an inner circumferential surface of the casing.

According to another embodiment of the present disclosure, provided is a cold trap used for a high pressure substrate processing apparatus, the trap including: a casing having an internal space communicating with an inlet and an outlet; a cooling plate disposed in the internal space and cooling and primarily capturing byproducts included in mixed gas flowing into the internal space from a substrate processing area through the inlet; and a cooling medium line accommodating a cooling medium while being disposed behind the cooling plate along a flow direction of the mixed gas from the inlet toward the outlet in the internal space and connected to the cooling plate to discharge heat from the mixed gas to the cooling medium, wherein the cooling medium line defines a well space for cooling and secondarily capturing the byproducts.

The cooling medium line may include a cooling coil wound around a winding axis to define the well space.

The cooling plate may be coupled to the cooling coil.

The cooling plate may include a hollow part communicating with the cooling medium line and receiving the cooling medium.

An entire section of the cooling plate along an outer peripheral direction may allow the mixed gas to flow through by being spaced apart from an inner circumferential surface of the casing.

The trap may further include a filter disposed behind the well space along the flow direction, wherein a gap between the cooling plate and the inlet is greater than a gap between the filter and the outlet.

According to yet another embodiment of the present disclosure, provided is a high pressure substrate processing apparatus including: an internal chamber accommodating a substrate to be processed; an external chamber accommodating the internal chamber; a gas supply module configured to supply a reaction gas for processing the substrate to the internal chamber to reach a first pressure higher than atmospheric pressure, and to supply a protective gas to a space between the external chamber and the internal chamber to reach a second pressure set in relation to the first pressure; a gas exhaust module including a gas exhaust line communicating with the internal chamber and a gas discharge device installed at the gas exhaust line and configured to regulate the discharge of mixed gas including the reaction gas and byproducts resulting from the processing; and a cold trap including a cooling plate for capturing the byproducts by cooling the mixed gas and disposed in front of the gas discharge device while communicating with the gas exhaust line.

The cold trap may be disposed in the external chamber to be exposed to the second pressure externally due to the protective gas and to be exposed to the first pressure internally due to the mixed gas.

The first pressure may be tens of atmospheres (ATM), and a difference between the first pressure and the second pressure may be 2 ATM or less.

The cold trap may include the cooling plate for cooling and primarily capturing the byproducts included in the mixed gas, and a cooling coil defining a well space for cooling and secondarily capturing the byproducts.

### BRIEF DESCRIPTION OF THE DRAWINGS

FIG. 1 is a conceptual diagram of a high pressure substrate processing apparatus according to an embodiment of the present disclosure.
FIG. 2 is a partial cross-sectional view showing a specific relationship between a chamber and a cold trap shown in FIG. 1.
FIG. 3 is a perspective view showing a structure of the cold trap in FIG. 1.
FIG. 4 is a cross-sectional view showing a relationship between a casing and a cooling plate shown in FIG. 3.
FIG. 5 is an exploded perspective view showing a main component of the cold trap according to a modified example of the cold trap in FIG. 3.
FIG. 6 is a partial cutaway perspective view showing a main component of the cold trap according to another embodiment of the present disclosure.
FIG. 7 is a partial cutaway perspective view showing a main component of the cold trap according to a modified example of the cold trap in FIG. 6.

### DETAILED DESCRIPTION

Hereinafter, embodiments of the present disclosure are described in detail with reference to the accompanying drawings.

The present disclosure is not limited to the embodiments described below, may be variously modified, and may be implemented in various forms. These embodiments are provided only to make the present disclosure complete and allow those skilled in the art to completely appreciate the scope of the present disclosure. Therefore, it should be understood that the present disclosure is not limited to the embodiments disclosed below, and includes substitution or addition of a configuration in one embodiment with or to a configuration in another embodiment, as well as all modifications, equivalents, or substitutions, included in the spirit and scope of the present disclosure.

It should be understood that the accompanying drawings are provided only to facilitate understanding of the embodiments of the present disclosure, and the spirit of the present disclosure is not limited to the accompanying drawings and includes all the modifications, equivalents and substitutions included in the spirit and scope of the present disclosure. In consideration of convenience of understanding, the size or thickness of a component may be exaggeratedly expressed as larger or smaller in the drawings. However, the scope of the present disclosure should not be interpreted as being limited by this expression.

Terms used in the specification are used only to describe the specific implementation examples or embodiments rather than limiting the present disclosure. Here, a term of a singular number includes its plural number unless explicitly interpreted otherwise in the context. Terms "include", "have", and the like used in the specification specify the presence of features, numerals, steps, operations, components, parts, or combinations thereof, mentioned in the specification. That is, it should be understood that the term "include" or "have" does not preclude the presence or addition of one or more other features, numerals, operations, components, parts, or combinations thereof, which is mentioned in the specification.

Terms including ordinal numbers such as "first" and "second" may be used to describe various components. However, these components are not constrained by these terms. These terms are used only to distinguish one component and another component from each other.

It should be understood that if one component is referred to as being "connected to" or "coupled to" another component, one component may be directly connected or coupled to another component, or may be connected or coupled to another component while having a third component interposed therebetween. On the other hand, it should be understood that if one component is referred to as being "directly connected to" or "directly coupled to" another component, one component may be connected or coupled to another component without a third component interposed therebetween.

It should be understood that when a component is referred to as being "on" or "below" another component, the component may be "directly on" another component, or may have a third component interposed therebetween.

Unless defined otherwise, it should be understood that all the terms including technical and scientific terms used herein have the same meanings as those generally understood by those skilled in the art to which the present disclosure pertains. Such terms as those defined in a generally used dictionary are to be interpreted as having meanings equal to the contextual meanings in the relevant field of art, and are not to be interpreted as having ideal or excessively formal meanings unless clearly defined as such in the present application.

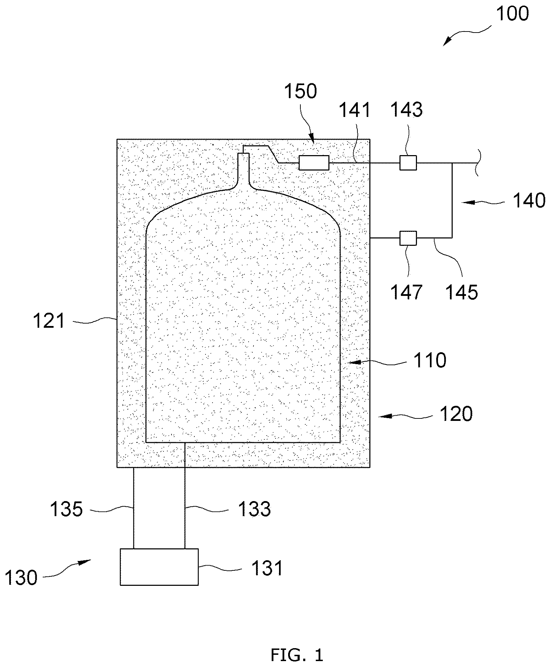

FIG. 1 is a conceptual diagram of a high pressure substrate processing apparatus according to an embodiment of the present disclosure.

Referring to this drawing, a high pressure substrate processing apparatus 100 may include an internal chamber 110, an external chamber 120, a gas supply module 130, a gas exhaust module 140, and a cold trap 150.

The internal chamber 110 may have a housing (internal housing) forming a processing area that accommodates a substrate. The housing may have a door disposed on the bottom that opens and closes the processing area. The internal chamber 110 may be made of a non-metallic material, for example, quartz, to reduce a risk of contamination of the substrate in a high temperature and high pressure working environment. The substrate may be, for example, a semiconductor wafer mounted on a loading stand. The substrate is not limited to the wafer, and may be any other base structure for making a circuit. For example, the substrate may also include glass for producing a display. The loading stand may be a boat that loads one or more substrates thereon.

The external chamber 120 may include a housing (external housing) 121 having a protecting area that accommodates the internal chamber 110. The housing 121 may also have a door disposed at a lower part. The door (external door) may open the protecting area by being interlocked with a movement of the door (internal door) of the internal chamber 110. The internal chamber 110 may be mounted in the external chamber 120. Unlike the internal chamber 110, the external chamber 120 may be made of a metal material because the external chamber 120 is free from a contamination problem.

The gas supply module 130 is a component for supplying a gas to the internal chamber 110 and the external chamber 120. The gas supply module 130 may have a gas supplier 131 that serves as a gas source. The gas supplier 131 may selectively provide a reaction gas to the internal chamber 110, such as hydrogen gas (H₂), deuterium gas (D₂), fluorine gas (F₂), ammonia gas (NH₃), chlorine gas (Cl₂), or nitrogen gas (N₂). The gas supplier 131 may provide the external chamber 120 with, for example, nitrogen gas or argon gas (Ar), which is an inert gas, as a protective gas. The reaction gas and the protective gas may be supplied to the internal chamber 110 and the external chamber 120 through a reaction gas line 133 and a protective gas line 135, respectively. The protective gas supplied to the external chamber 120 may be specifically supplied to a space (protection space) between the external chamber 120 and the internal chamber 110. The reaction gas and the protective gas may be simply referred to as a process gas.

The process gas may be supplied to the chambers 110 and 120 to reach a pressure higher than atmospheric pressure (high pressure), for example, from several atmospheres to several tens of atmospheres, or more. When the process gas is supplied to allow a pressure in the internal chamber 110 to reach a first pressure and a pressure in the external chamber 120 (protective space) to reach a second pressure, these pressures may be maintained at a set relationship (range). For example, the second pressure may be set to be substantially equal to or slightly greater than the first pressure. Such a pressure relationship may prevent leakage of the reaction gas from the internal chamber 110 and breakage of the internal chamber 110. The second pressure may be set to be slightly lower than the first pressure, and a similar effect as in the relationship described above may be achieved even in that case. A pressure difference between the first pressure and the second pressure may be, for example, 2 atmospheres (ATM) or less.

The gas exhaust module 140 is a component for exhausting the process gas. A gas exhaust line 141 may be connected to an upper part of the internal chamber 110 to exhaust the reaction gas from the internal chamber 110. A gas discharge device 143 may be installed at the gas exhaust line 141. The gas discharge device 143 may be a gas discharge valve that regulates a discharge amount of the reaction gas. The first pressure may be maintained or regulated to be lower depending on an operation of the gas discharge device 143. The reaction gas may be mixed with byproducts resulting from processing of the substrate. The reaction gas and the byproducts may be mixed with each other, and thus be collectively referred to as mixed gas.

Similarly, a gas exhaust line 145 communicating with the external chamber 120 and a gas discharge device 147 installed at the gas exhaust line 145 may be provided to also discharge the protective gas from the external chamber 120. The reaction gas may be diluted with the protective gas to have a lower concentration if the gas exhaust lines 141 and 145 are integrated into one line.

The cold trap 150 is a component for capturing the byproducts among the mixed gas flowing along the gas exhaust line 141. The byproducts may be present in a gaseous form in the high-temperature environment and solidified as the byproducts are cooled. The cold trap 150 may also be disposed in front of the gas discharge device 143 along a gas discharge direction from the gas exhaust line 141. The cold trap 150 may also be disposed inside the external chamber 120 while communicating to the gas exhaust line 141, and is not limited thereto. In an alternative embodiment, the cold trap 150 may be disposed outside the external chamber 120.

According to this configuration, the gas discharge device 143 may be used to regulate (lower) the first pressure by discharging the reaction gas from the internal chamber 110. Regulating the first pressure may involve regulating the second pressure, which has the set relationship with the first pressure. The byproducts may not be mixed with the protective gas, and accordingly, the gas discharge device 147 for regulating the second pressure may not be adversely affected by the byproducts. On the other hand, the gas discharge device 143 for regulating the first pressure may be adversely affected by the byproducts. However, the gas discharge device 143 may be operated normally without any adverse effects of the byproducts by disposing the cold trap 150 in front of the gas discharge device 143 to thus capture the byproducts before the byproducts flow into the gas discharge device 143. As a result, the cold trap 150 may have an important role in regulating not only the first pressure but also the second pressure related to the first pressure.

The cold trap 150 may be disposed in the external chamber 120, thus capturing the byproducts within the external chamber 120. The byproducts may not have the adverse effect on a range of parts beyond the external chamber 120, specifically a part of the gas exhaust line 141 following the cold trap 150, the gas discharge device 143, a scrubber, and the like.

The cold trap 150 may also be exposed to the first pressure internally because the cold trap 150 communicates with the internal chamber 110 through the gas exhaust line 141. The cold trap 150 may be exposed to the second pressure externally due to the protective gas. The second pressure may maintain its set relationship with the first pressure, and their pressure difference may not be great. Even if the first pressure reaches tens of atmospheres, the cold trap 150 may be exposed to the pressure difference rather than the first pressure. Accordingly, the cold trap 150 may not need a high-level high-pressure design corresponding to tens of atmospheres.

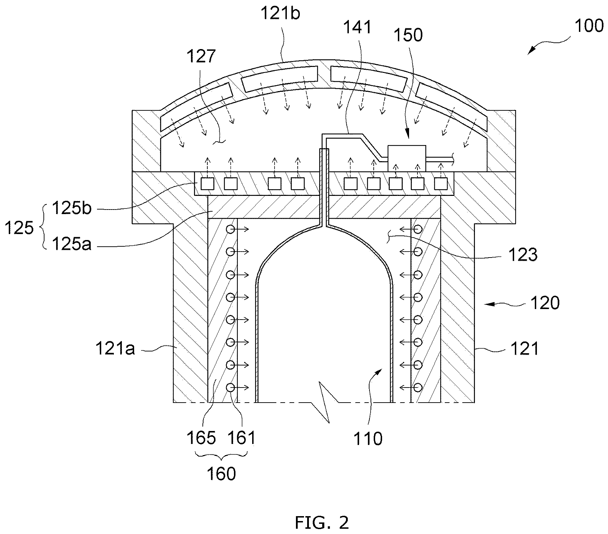

FIG. 2 is a partial cross-sectional view showing a specific relationship between the chamber and the cold trap shown in FIG. 1.

Referring to this drawing, the housing 121 of the external chamber 120 may include a body part 121a and a cover part 121b. The body part 121a may have a substantially cylindrical shape, and the cover part 121b may have a substantially dome shape.

The protecting area may be partitioned into two regions by a partition plate 125. The partition plate 125 may be disposed below the cover part 121b while being supported by the body part 121a. The partition plate 125 may define a high-temperature region 123 together with the body part 121a, and define a low-temperature region 127 together with the cover part 121b. The high-temperature region 123 and the low-temperature region 127 may communicate with each other through a communication hole (not shown) or the like formed in the partition plate 125, and thus have the same pressure (second pressure).

In the high-temperature region 123, a heating module 160 may also be disposed in addition to the internal chamber 110. The heating module 160 may include a heater 161 and a heat insulation block 165. The heater 161 may surround the internal chamber 110. The protective gas in the high-temperature region 123 and the reaction gas in the internal chamber 110 may be heated by heat generated by the heater 161. A temperature of the reaction gas may reach hundreds to thousands of degrees Celsius due to the operation of the heater 161. The heat insulation block 165 may prevent heat generated by the heater 161 from being transferred to the body part 121a.

A heat insulation layer 125a may be disposed on a lower part of the partition plate 125 to correspond to the heater 161. The heat insulation layer 125a may be disposed on top of the heating module 160 to face the heater 161.

A cooling layer 125b may be disposed on an upper part of the partition plate 125. The cooling layer 125b may have a space that accommodates a cooling medium, for example, cooling water. The cover part 121b may also have a space that accommodates the cooling medium to correspond to the cooling layer 125b. The cooling medium is not limited to cooling water, and may also be a cooling gas.

The cooling medium accommodated in the cover part 121b and/or the cooling layer 125b may fill the low-temperature region 127 with cold air. Accordingly, the low-temperature region 127 may be maintained at a significantly lower temperature than that in the high-temperature region 123, for example, a temperature that is several to several tenths of that in the high-temperature region 123.

The cold trap 150 may be installed at the gas exhaust line 141 while being disposed in the low-temperature region 127. The cold trap 150 may be affected by the cold air in addition to the mixed gas flowing along the gas exhaust line 141 and the cold trap 150.

According to this configuration, the mixed gas may flow along the gas exhaust line 141 from the high-temperature region 123 to the low-temperature region 127 and flow into the cold trap 150. Accordingly, the mixed gas may pass through the cold trap 150 at a temperature significantly lower than a high temperature at which the substrate is processed. The low-temperature region 127 may function to improve the cooling performance of the cold trap 150 by providing preliminary or preemptive cooling of the mixed gas. As a result, a cooling load in the cold trap 150 may be reduced or cooling efficiency of the cold trap 150 may be increased. Capture efficiency of the cold trap 150 for the byproducts may also be improved.

In an alternative embodiment, the protecting area may form one space that is not partitioned into the high-temperature region 123 and the low-temperature region 127 (see FIG. 1). The cold trap 150 may be disposed in the one space, for example, in a region that is least affected by heat generated from the heater 161.

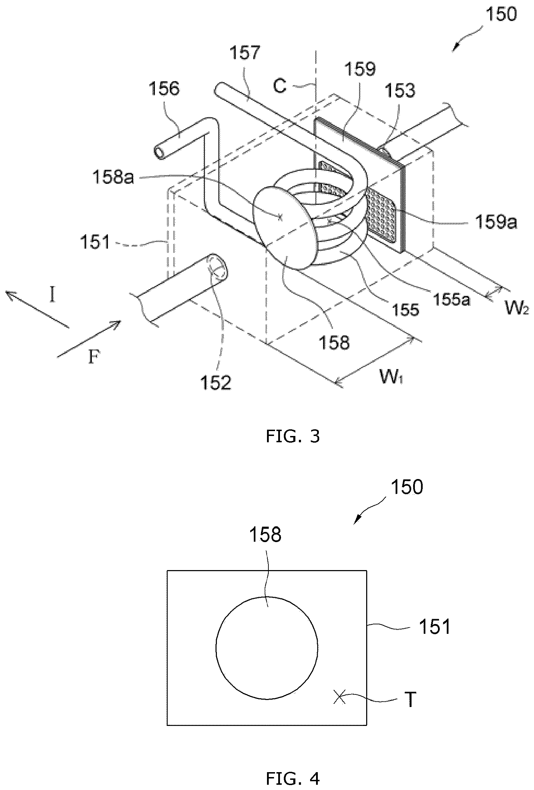

A specific structure of the cold trap 150 is described with reference to FIGS. 3 and 4. FIG. 3 is a perspective view showing the structure of the cold trap in FIG. 1, and FIG. 4 is a cross-sectional view showing a relationship between a casing and a cooling plate shown in FIG. 3.

Referring to these drawings, the cold trap 150 may include a casing 151, a cooling coil 155, a cooling plate 158, and a filter 159.

The casing 151 may be a hollow body having an internal space. The casing 151 may have, for example, a substantially rectangular parallelepiped shape. The casing 151 may be made of, for example, a metal or synthetic resin. An inlet 152 may be disposed at one side of the casing 151, and an outlet 153 may be disposed at the other side. Both the inlet 152 and the outlet 153 may communicate with the gas exhaust line 141 (see FIG. 1). The byproducts may be captured in the casing 151 while the mixed gas flows along a flow direction F from the inlet 152 to the outlet 153.

The cooling coil 155 is a component disposed in the internal space to cool the mixed gas and the cooling plate 158. The cooling coil 155 may be a part of a cooling medium line, and may be wound into a coil shape centered around a winding axis C. The cooling coil 155 may accommodate the cooling medium and extend a time during which the cooling medium remains in the internal space. The cooling medium line may further include a cooling medium supply line 156 and a cooling medium return line 157, which are connected to the cooling coil 155. The cooling medium may be supplied to the cooling coil 155 through the cooling medium supply line 156 and flow out of the cooling coil 155 through the cooling medium return line 157. The cooling medium supply line 156 and the cooling medium return line 157 may extend along an intersecting direction I at least partially intersecting the flow direction F. The cooling medium line may communicate with a supply line that supplies the cooling medium to the cover part 121b and the partition plate 125 (see FIG. 2).

The cooling plate 158 is a component for capturing the byproducts by cooling the mixed gas. The cooling plate 158 may face the inlet 152. A central region of the cooling plate 158 may be disposed at a height corresponding to that of the inlet 152. The cooling plate 158 may be flat and solid. The cooling plate 158 is exemplified as being a circular plate, and the present disclosure is not limited thereto. In an alternative embodiment, the cooling plate 158 may be a polygonal plate, such as a square plate.

The cooling plate 158 may be coupled to the cooling medium line, specifically, the cooling coil 155. The cooling plate 158 may be welded to, for example, the cooling coil 155. The cooling plate 158 may cause heat from the mixed gas to be discharged to the cooling coil 155, specifically, to the cooling medium. Heat may be transferred to the cooling coil 155 through the cooling plate 158. The cooling plate 158 may be disposed in front of the cooling coil 155 along the flow direction F, and disposed to be parallel to the winding axis C of the cooling coil 155. The cooling plate 158 may be coupled to the cooling coil 155 rather than the casing 151, and an entire section of the cooling plate 158 along an outer peripheral direction (circumferential direction) may be spaced apart from an inner circumferential surface of the casing 151. The mixed gas may flow without restriction through a separation space T between the cooling plate 158 and the casing 151.

The filter 159 is a component for filtering out the byproducts from the internal space. The filter 159 may be disposed between the cooling coil 155 and the outlet 153. A mesh part 159a, which is a part of the filter 159, may be disposed at a height different from that of the outlet 153. The remaining part of the filter 159, except for the mesh part 159a, may be solid and block the flow of the mixed gas. A gap W2 between the filter 159 and the outlet 153 may be smaller than a gap W1 between the cooling plate 158 and the inlet 152.

According to this configuration, the byproducts in the mixed gas flowing into the internal space may be primarily solidified due to a cooling action by the cooling plate 158. An open space 158a as large as the gap W1 may allow a significant amount of byproducts to attach to the cooling plate 158. The byproducts may form, for example, a bell shape lying sideways in the open space 158a as the byproducts attach to the cooling plate 158.

The byproducts not captured by the cooling plate 158 may be secondarily captured by the cooling coil 155. The cooling coil 155 may also solidify the byproducts by using the action of the cooling medium. The byproducts may attach to an outer surface of the cooling coil 155 or may be separated from the outer surface and accumulated in a well space 155a defined by the cooling coil 155. Even if some of the byproducts float, the corresponding byproducts may be filtered out by the filter 159. In an alternative embodiment, the well space 155a may have an overall cylindrical shape by extending the cooling medium line in a zigzag shape.

The byproducts may be solidified twice in the open space 158a and the well space 155a and thus be captured more reliably. Furthermore, the byproducts floating through the filter 159 may not be externally discharged. The byproducts may be thoroughly controlled, thus preventing the gas flow path following the cold trap 150 from being clogged due to the byproducts.

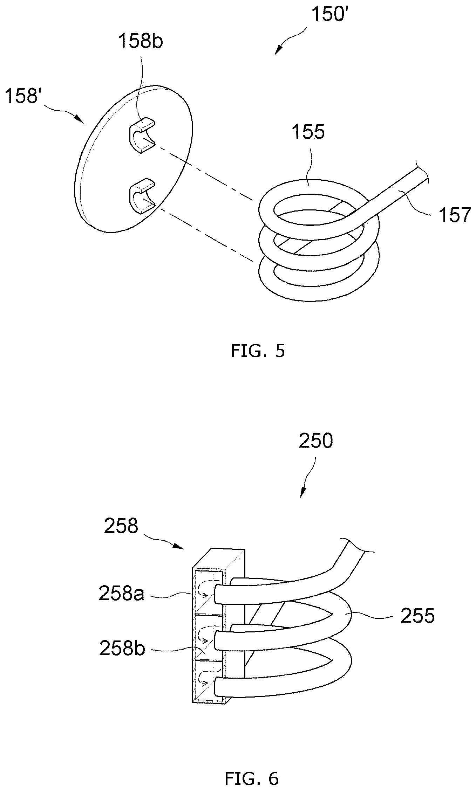

FIG. 5 is an exploded perspective view showing a main component of the cold trap according to a modified example of the cold trap in FIG. 3.

Referring to this drawing, in a cold trap 150' according to the modified example, a cooling plate 158' may be coupled to the cooling coil 155 in a way other than the welding.

In detail, a hook part 158b may be installed at the cooling plate 158'. The hook part 158b may be welded to the cooling plate 158' or may be force-fitted using a groove and projection structure.

The hook part 158b may be fitted into the cooling coil 155, thus connecting the cooling plate 158' to the cooling coil 155. The cooling plate 158' may be connected to the cooling coil 155 through the hook part 158b.

Even in this case, heat from the cooling plate 158' may be transferred to the cooling coil 155 through the hook part 158b without any problem.

FIG. 6 is a partial cutaway perspective view showing a main component of the cold trap according to another embodiment of the present disclosure.

Referring to this drawing, in a cold trap 250 having another form, a cooling plate 258 may communicate with a cooling coil 255. As a result, the cooling medium flowing within the cooling coil 255 may flow into the cooling plate 258. The cooling plate 258 may occupy a space independent from the cooling coil 255. For example, the cooling coil 255 may be disposed outside the cooling plate 258.

The cooling plate 258 may have a hollow-shaped container 258a. A partition wall 258b may be disposed in a hollow part of the container 258a. The partition wall 258b may form a path through which the cooling medium flows in the hollow part.

According to this configuration, the cooling medium may come into more direct contact with the mixed gas or the byproducts than in the previous embodiment. Accordingly, heat from the mixed gas may be more efficiently conducted to the cooling medium.

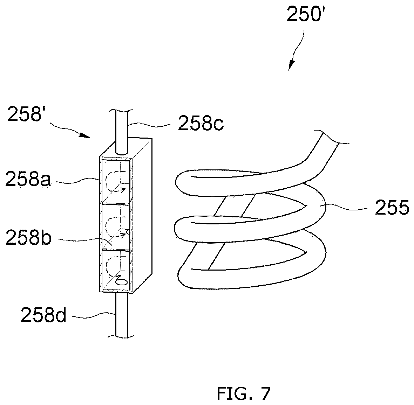

FIG. 7 is a partial cutaway perspective view showing a main component of the cold trap according to a modified example of the cold trap in FIG. 6.

Referring to this drawing, in a cold trap 250' according to this modified example, a cooling plate 258' may receive the cooling medium through a separate path without communicating with the cooling coil 255. A separate cooling medium supply line 258c and a separate cooling medium return line 258d may communicate with the cooling plate 258'. These lines 258c and 258d may form parts of the cooling medium line. A partition wall 258b within the container 258a may form a cooling medium flow path (not shown) connecting these lines 258c and 258d, for example, through a hole.

According to this configuration, the cooling plate 258' may not be connected with the cooling coil 255. In addition, only the cooling plate 258' may be disposed in the internal space without the cooling coil 255, thereby capturing the byproducts.

This specification describes the substrate processing apparatus 100 having the dual chamber as an example, and the present disclosure is not limited thereto. The component such as the cold trap 150, 150', 250, or 250' may also be applied to a processing apparatus having a single chamber. The single chamber may include one housing and one door. The substrate may be disposed in the processing area of the chamber, and the reaction gas for processing the substrate may be supplied thereto. The housing and the door may correspond to the internal housing and the internal door in the double chamber described above. The reaction gas may have a pressure equal to or lower than/higher than the atmospheric pressure. The cold trap may be disposed in front of the gas discharge device.

The components such as the cold trap 150, 150', 250, or 250' may also be applied to a semi-dual chamber, which is an intermediate form between the double chamber and the single chamber. The semi-dual chamber may have two housings (internal housing and external housing) and one door. The two housings may be coupled to each other by their own shapes or form a closed space (corresponding to the protection space) by being coupled to each other while intervening a separate member therebetween. As in the previous embodiment, the substrate may be disposed in the processing area of the internal housing and the reaction gas may be injected thereto, and the protective gas may be injected into the closed space. Unlike the previous embodiments, the door may not be completely protected by the protective gas and exposed externally. In this respect, the door may correspond to the external door in the previous embodiment. The door may open and close the processing area. The cold trap 150, 150', 250, or 250' may be disposed in the closed space.

The specification exemplifies a batch type processing apparatus, and the present disclosure is not limited thereto. The present disclosure may also be applied to a single wafer type processing apparatus as it is.

As set forth above, the high pressure substrate processing apparatus of the present disclosure configured as described above may have the cold trap installed in front of the gas discharge device and operated to thus prevent the byproducts from having the adverse effect on the gas discharge
device and the following parts if the gas in the internal chamber is exhausted while the gas is supplied to each of the internal chamber accommodating the substrate and the external chamber surrounding the internal chamber to reach the first pressure and the second pressure. Therefore, the gas pressure difference between the internal chamber and the external chamber can be more accurately regulated. The cold trap may be disposed in the external chamber, thus preventing the adverse effect of the byproducts from extending beyond the external chamber.

The cold trap may not need the high-level high-pressure design despite the high pressure processing of the substrate if the cold trap is disposed in the external chamber to be internally exposed to the first pressure higher than the atmospheric pressure and externally exposed to the second pressure set in the certain relationship with the first pressure.

The cold trap may be disposed in the low-temperature region distinct from the high-temperature region within the external chamber, thus more effectively cooling the exhaust gas from the internal chamber and capturing the byproducts more efficiently.

## Claims

1. A high pressure substrate processing apparatus comprising:
an internal chamber accommodating a substrate to be processed;
an external chamber including a housing having a protecting area and a partition plate partitioning the protecting area into a high-temperature region accommodating the internal chamber and a low-temperature region having a temperature lower than that in the high-temperature region;
a gas supply module configured to supply a reaction gas for processing the substrate to the internal chamber to reach a first pressure higher than atmospheric pressure, and to supply a protective gas to a space between the external chamber and the internal chamber to reach a second pressure set in relation to the first pressure;
a gas exhaust module including a gas exhaust line communicating with the internal chamber and passing through the low-temperature region and configured to exhaust mixed gas including the reaction gas and byproducts resulting from the processing; and
a cold trap including a cooling plate for cooling and capturing the byproducts in the mixed gas, and disposed in the low-temperature region while communicating with the gas exhaust line.

2. The apparatus of claim 1, wherein the cold trap further includes a cooling medium line through which a cooling medium flows internally, and
the cooling plate is connected to the cooling medium line and discharges heat from the mixed gas to the cooling medium.

3. The apparatus of claim 2, wherein the cooling medium line includes a cooling coil wound into a coil shape, and
the cooling plate is coupled to the cooling coil.

4. The apparatus of claim 2, wherein the cooling plate includes a hollow part communicating with the cooling medium line and receiving the cooling medium.

5. The apparatus of claim 1, wherein the cold trap further includes a casing accommodating the cooling plate, and
an entire section of the cooling plate along an outer peripheral direction allows the mixed gas to flow through by being spaced apart from an inner circumferential surface of the casing.

6. A cold trap used for a high pressure substrate processing apparatus, the trap comprising:
a casing having an internal space communicating with an inlet and an outlet;
a cooling plate disposed in the internal space and cooling and primarily capturing byproducts included in mixed gas flowing into the internal space from a substrate processing area through the inlet; and
a cooling medium line accommodating a cooling medium while being disposed behind the cooling plate along a flow direction of the mixed gas from the inlet toward the outlet in the internal space and connected to the cooling plate to discharge heat from the mixed gas to the cooling medium,
wherein the cooling medium line defines a well space for cooling and secondarily capturing the byproducts.

7. The trap of claim 6, wherein the cooling medium line includes a cooling coil wound around a winding axis to define the well space.

8. The trap of claim 7, wherein the cooling plate is coupled to the cooling coil.

9. The trap of claim 6, wherein the cooling plate includes a hollow part communicating with the cooling medium line and receiving the cooling medium.

10. The trap of claim 6, wherein an entire section of the cooling plate along an outer peripheral direction allows the mixed gas to flow through by being spaced apart from an inner circumferential surface of the casing.

11. The trap of claim 6, further comprising a filter disposed behind the well space along the flow direction,
wherein a gap between the cooling plate and the inlet is greater than a gap between the filter and the outlet.

12. A high pressure substrate processing apparatus comprising:
an internal chamber accommodating a substrate to be processed;
an external chamber accommodating the internal chamber;
a gas supply module configured to supply a reaction gas for processing the substrate to the internal chamber to reach a first pressure higher than atmospheric pressure, and to supply protective gas to a space between the external chamber and the internal chamber to reach a second pressure set in relation to the first pressure;
a gas exhaust module including a gas exhaust line communicating with the internal chamber and a gas discharge device installed at the gas exhaust line and configured to regulate the discharge of mixed gas including the reaction gas and byproducts resulting from the processing; and
a cold trap including a cooling plate for capturing the byproducts by cooling the mixed gas and disposed in front of the gas discharge device while communicating with the gas exhaust line.

13. The apparatus of claim 12, wherein the cold trap is disposed in the external chamber to be exposed to the second pressure externally due to the protective gas and to be exposed to the first pressure internally due to the mixed gas.

14. The apparatus of claim 13, wherein the first pressure is tens of atmospheres (ATM), and
a difference between the first pressure and the second pressure is 2 ATM or less.

15. The apparatus of claim 12, wherein the cold trap includes
the cooling plate for cooling and primarily capturing the byproducts included in the mixed gas, and
a cooling coil defining a well space for cooling and secondarily capturing the byproducts.
